# EUROPÄISCHE PATENTSCHRIFT

(11) **EP 1 027 735 B1**
(45) Veröffentlichungstag und Bekanntmachung des Hinweises auf die Patenterteilung: **07.06.2006**
(21) Anmeldenummer: 99953668.3
(22) Anmeldetag: 01.09.1999
(51) Int. Cl.: H01L 29/808, H01L 29/10

(54) **SILIZIUMCARBID-JUNCTION-FELDEFFEKTTRANSISTOR**
SILICON CARBIDE JUNCTION FIELD EFFECT TRANSISTOR
TRANSISTOR A EFFET DE CHAMP A JONCTIONS CARBURE DE SILICIUM

(30) Priorität: 02.09.1998 DE 19839969
(43) Veröffentlichungstag der Anmeldung: 16.08.2000
(73) Patentinhaber: Infineon Technologies AG, 81669 München (DE)
(72) Erfinder: TIHANYI, Jenoe, D-85551 Kirchheim (DE); MITLEHNER, Heinz, D-91080 Uttenreuth (DE); BARTSCH, Wolfgang, D-91054 Erlangen (DE)
(74) Vertreter: Kottmann, Heinz Dieter
(86) Internationale Anmeldenummer: PCT/DE1999/002755
(87) Internationale Veröffentlichungsnummer: WO 2000/014810

(56) Entgegenhaltungen:
- DE-C- 19 644 821
- US-A- 3 254 280
- US-A- 5 378 642
- LEVINSHTEIN M E ET AL: "NATURE OF THE 1/F NOISE IN 6H-SIC" SEMICONDUCTOR SCIENCE AND TECHNOLOGY,GB,INSTITUTE OF PHYSICS. LONDON, Bd. 9, Nr. 11, 1. November 1994 (1994-11-01), Seiten 2080-2084, XP000476116 ISSN: 0268-1242

## Beschreibung

Die Erfindung betrifft einen Siliziumcarbid Feldeffekttransistor (FET) mit einem Siliziumcarbidkörper, in dem p- und n-leitende Schichten vorhanden sind, und mit Source-, Drain- und Gateelektroden.

Siliziumcarbid Feldeffekttransistoren können als Hochspannungsbauelemente beispielsweise in Kaskodenschaltungen eingesetzt werden. Sie haben den Vorteil, daß sie mit relativ geringem Aufwand hergestellt werden können, da bei ihnen Dotierungen durch Implantationen ohne weiteres vorgenommen werden können.

Bisher gibt es für Siliziumcarbid Feldeffektransistoren Vertikalstrukturen, deren Integration infolge der auf der Rückseite des Siliziumcarbidkörpers gelegenen Drainelektrode problematisch ist.

Silizium Carbid-Junction -Feldeffekttransistoren mit Lateralstruktur sind aus Dokumenten DE-C-196 44 821, US-A-3 254 280, US-A-5 378 642 Levinshtein M. et al. "Nature of the 1/F Noise in 6H-SiC", Semiconductor Sci. and Tec., 9(11), p. 2080-2084 bekannt.

Es ist daher Aufgabe der vorliegenden Erfindung, einen Siliziumcarbid Feldeffekttransistor mit Lateralstruktur anzugeben, der einfach herstellbar ist und sich durch eine große Hochspannungsfestigkeit auszeichnet.

Diese Aufgabe wird bei einem Siliziumcarbid Feldeffekttransistor der eingangs genannten Art erfindungsgemäß dadurch gelöst, daß
- die p- und n-leitenden Siliziumcarbid-Schichten paarweise in lateraler Richtung parallel zu einer Hauptoberfläche des Siliziumcarbidkörpers in diesen eingebettet sind,
- die Source- und Drainelektroden aus die p- und n-leitenden Siliziumcarbidschichten von der einen Hauptoberfläche aus durchsetzenden und mit hochdotiertem Siliziumcarbid des einen Leitungstyps gefüllten Gräben (Trenchen) bestehen und
- die Gateelektrode aus einem die p- und n-leitenden Siliziumcarbidschichten von der einen Hauptoberfläche aus durchsetzenden und mit hochdotiertem Siliziumcarbid des anderen, zum einen Leitungstyp entgegengesetzten Leitungstyps gefüllten und an seinem Rand mit einer Isolierschicht belegten Graben (Trench) besteht.

In einer Weiterbildung der Erfindung ist vorgesehen, daß die Dotierungskonzentration der p- und n-leitenden Siliziumcarbidschichten nicht höher als 10¹³ Ladungsträger/cm² ist. Auch ist vorteilhaft, daß die Trenche für die Source- und Gateelektroden den Trench für die Drainelektrode wenigstens teilweise umgeben. Die n- und p-leitenden Siliziumcarbidschichten können durch Ionenimplantation und epitaktische Abscheidung auf einem.Siliziumcarbid-Grundkörper erzeugt werden.

Die Erfindung schafft so einen Siliziumcarbid Feldeffekttransistor in Lateralstruktur, welche mit den derzeit zur Verfügung stehenden Mitteln ohne weiteres herstellbar ist.

So werden auf einem nicht dotierten Siliziumcarbid-Grundkörper nicht dotierte epitaktische Schichten abgeschieden, die eine Epistruktur bilden. In diese Epistruktur sind paarweise n- und p-leitende Siliziumcarbidschichten eingeschlossen, die mittels Ionenimplantation von n- bzw. p-leitenden Dotierstoffen, wie beispielsweise Stickstoff bzw. Bor und/oder Aluminium erzeugt sind. Die oberste Schicht dieser Epistruktur bleibt undotiert.

In die Epistruktur werden sodann schmale Gräben (Trenche) eingeätzt, welche sodann für die Sourceelektrode und die Drainelektrode mit beispielsweise n⁺-dotiertem Siliziumcarbid und für die Gateelektrode nach Abscheidung einer Isolierschicht mit p⁺-dotiertem Siliziumcarbid epitaktisch aufgefüllt werden. Die in den Trenchen für Source, Drain und Gate so aufgetragenen n⁺- und p⁺-leitenden Siliziumcarbidschichten werden schließlich bis zu der obersten undotierten Siliziumcarbidschicht zurückgeätzt und auf diese Weise strukturiert.

In vorteilhafter Weise kann für die Elektroden eine Geometrie gewählt werden, bei der die Gräben (Trenche) für die Sourceelektrode und die Gateelektrode die Drainelektrode umgeben.

Die Metallisierung des so aufgebauten Siliziumcarbid-Junction-Feldeffekttransistors kann in üblicher Weise erfolgen. In vorteilhafter Weise können so beispielsweise Leiterbahnen aus Aluminium oder aus polykristallinem Silizium eingesetzt werden.

Die Dotierungskonzentration in den p- bzw. n-leitenden Siliziumcarbidschichten sollte zweckmäßigerweise 10¹³ cm⁻² nicht überschreiten. Durch diese obere Begrenzung wird erreicht, daß bei einer angelegten Drainspannung die p- und n-leitenden Siliziumcarbidschichten in lateraler bzw. Querrichtung früher ausgeräumt werden, bevor ein Durchbruch auftritt, so daß sich der Siliziumcarbid Feldeffekttransistor dann durch eine hohe Durchbruchsfestigkeit auszeichnet. Mit anderen Worten, der erfindungsgemäße Siliziumcarbid Feldeffekttransistor hat eine hohe Durchbruchsspannung bei niedrigem Einschaltwiderstand.

Nachfolgend wird die Erfindung anhand der Zeichnungen näher erläutert. Es zeigen:
- Figur 1: einen Schnitt durch einen Siliziumcarbidkörper, in dem p- und n-leitende Siliziumcarbidschichten paarweise in einer Epistruktur eingebettet sind,
- Figur 2: einen Schnitt durch einen Siliziumcarbid Feldeffekttransistor nach einem Ausführungsbeispiel der Erfindung und
- Figur 3: eine Draufsicht auf ein mögliches Layout des Siliziumcarbid Feldeffekttransistors von Fig. 2.

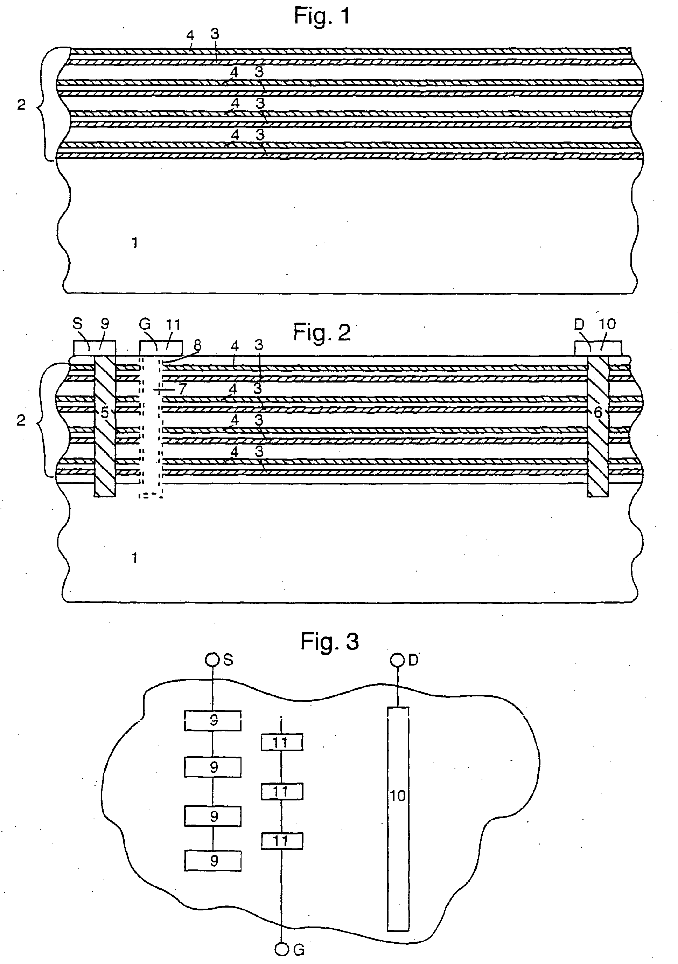

Fig. 1 zeigt einen undotierten Siliziumcarbid-Grundkörper 1, auf dem eine Epistruktur 2 aus dotiertem Siliziumcarbid vorgesehen ist, in die p-leitende Siliziumcarbidschichten 3 und n-leitende Siliziumcarbidschichten 4 paarweise eingebettet sind. Diese p-leitenden Siliziumcarbidschichten 3 und diese n-leitenden Siliziumcarbidschichten 4 weisen eine Dotierungskonzentration auf, die 10¹³ Ladungsträger cm⁻² nicht überschreiten sollte. Damit wird erreicht, daß bei einem fertigen Siliziumcarbid Feldeffekttransistor bei angelegter Drainspannung die Schichten 3, 4 in Quer- bzw. Lateralrichtung früher ausgeräumt werden, bevor ein Durchbruch auftritt. Auf diese. Weise kann, ähnlich wie bei Junction-Trench-Feldeffekttransistoren, eine hohe Durchbruchsspannung bei niedrigem Einschaltwiderstand erzielt werden.

Die Epistruktur 2 wird in der Weise erzeugt, daß auf den Siliziumcarbid-Grundkörper 1 stufenweise epitaktische Schichten aufgetragen werden, wobei dabei jeweils eine Ionenimplantation mit Bor und/oder Aluminium für die Schichten 3 bzw. Stickstoff für die Schichten 4 vorgenommen wird.

Nachdem auf den in Fig. 1 gezeigten Siliziumcarbidkörper aus dem Siliziumcarbid-Grundkörper 1 und der Epistruktur 2 noch eine oberste undotierte Schicht (vgl. Fig. 2) aufgetragen wurde, werden in die so erhaltene Struktur schmale Gräben (Trenche) für Source, Drain und Gate bis zu dem Siliziumcarbid-Grundkörper 1 geätzt. Diese Gräben (Trenche) werden mit n⁺-dotiertem Siliziumcarbid für eine Sourceelektrode 5 bzw. eine Drainelektrode 6 gefüllt. Der Gräben (Trench) für eine Gateelektrode 7 wird zunächst an seiner Wand mit einer Isolierschicht 8 versehen, was durch thermische Oxidation geschehen kann, und sodann in seinem Innenraum mit p⁺-dotiertem Siliziumcarbid aufgefüllt. Dieses Auffüllen der Gräben (Trenche) für die Source-, Drain- und Gateelektrode kann epitaktisch erfolgen. Die in die Gräben (Trenche) gefüllten n⁺- bzw. p⁺-leitenden Schichten werden auf ihrer Oberseite entweder zurückgeätzt oder abpoliert, bis die oberste, undotierte Siliziumcarbidschicht erreicht ist. Nach Auftragen von beispielsweise aus Aluminium bestehenden Elektroden 9, 10 und 1-1 für Source S, Drain D und Gate G liegt so schließlich der in Fig. 2 gezeigte Siliziumcarbid Feldeffekttransistor vor. Es kann dabei auch so vorgegangen werden, daß zur Herstellung der Sourceelektrode 9 und der Drainelektrode 10 eine durch Sputtern oder Aufdampfen aufgetragene Schicht aus vorzugsweise Nickel oder Permalloy (NiFe) entsprechend einem gewünschten Layout (vgl. beispielsweise Fig. 3) geätzt wird, während für die Gateelektrode 11 in bevorzugter Weise eine Ni-Al-Legierung verwendet wird. Diese Metallisierungen werden sodann bei vorzugsweise 980°C eingetempert und anschließend mit zusätzlich aufgetragenem Aluminium für ein Draht-Bonden oder aber mit lötfähigen Metallisierungen (z.B. NiAg) verstärkt.

Fig. 3 zeigt schließlich ein mögliches Layout (Draufsicht) für einen solchen Siliziumcarbid Feldeffekttransistor mit Sourceelektroden 9, Drainelektroden 10 und Gateelektroden 11. Die Sourceelektrode 9 und die Gateelektrode 11 können dabei so angeordnet werden, daß sie die Drainelektrode 10 umgeben.

## Patentansprüche

1. Siliziumcarbid Feldeffekttransistor mit einem Siliziumcarbidkörper (1, 2), in dem p- und n-leitende Schichten (3, 4) vorhanden sind, und mit Source-, Drain- und Gateelektroden (5, 6, 7),
**dadurch gekennzeichnet, daß**
- die p- und n-leitenden Siliziumcarbidschichten (3, 4) paarweise in lateraler Richtung parallel zu einer Hauptoberfläche des Siliziumcarbidkörpers (1, 2) in diesem eingebettet sind,
- die Source- und Drainelektroden (5, 6) aus die p- und n-leitenden Siliziumcarbidschichten (3, 4) von der einen Hauptoberfläche aus durchsetzenden und mit hochdotiertem Siliziumcarbid des einen Leitungstyps gefüllten Gräben (Trenchen) bestehen und
- die Gateelektrode (7) aus einem die p- und n-leitenden Siliziumcarbidschichten (3, 4) von der einen Hauptoberfläche aus durchsetzenden und mit hochdotiertem Siliziumcarbid des anderen, zum einen Leitungstyp entgegengesetzten Leitungstyps gefüllten und an seinen Wänden mit einer Isolierschicht (8) belegten Gräben (Trench) besteht.

2. Siliziumcarbid Feldeffekttransistor nach Anspruch 1,
**dadurch gekennzeichnet,**
**daß** die Dotierungskonzentration der p- und n-leitenden Siliziumcarbidschichten (3, 4) nicht höher als 10¹³ Ladungsträger/cm² ist.

3. Siliziumcarbid Feldeffekttransistor nach Anspruch 1 oder 2,
**dadurch gekennzeichnet,**
**daß** die Gräben (Trenche) für die Source- und Gateelektroden (5, 7) den Trench für die Drainelektrode (6) umgeben.

4. Siliziumcarbid Feldeffekttransistor nach einem der Ansprüche 1 bis 3,
**dadurch gekennzeichnet,**
**daß** die n- und p-leitenden Siliziumcarbidschichten (3, 4) durch Ionenimplantation und epitaktische Abscheidung auf einem Siliziumcarbid-Grundkörper (1) erzeugt sind.

## Claims

1. Silicon carbide field-effect transistor having a silicon carbide body (1, 2), in which p- and n-conducting layers (3, 4) are present, and having source, drain and gate electrodes (5, 6, 7),
**characterized**
**in that**
- the p- and n-conducting silicon carbide layers (3, 4) are embedded in the silicon carbide body (1, 2) in pairs in a lateral direction parallel to a main surface of said silicon carbide body,
- the source and drain electrodes (5, 6) comprise trenches that penetrate through the p- and n-conducting silicon carbide layers (3, 4) from the one main surface and are filled with highly doped silicon carbide of the first conduction type, and
- the gate electrode (7) comprises a trench that penetrates through the p- and n-conducting silicon carbide layers (3, 4) from the one main surface, is filled with highly doped silicon carbide of the second conduction type, which is opposite to the first conduction type, and is coated with an insulating layer (8) on its walls.

2. Silicon carbide field-effect transistor according to Claim 1,
**characterized**
**in that** the doping concentration of the p- and n-conducting silicon carbide layers (3, 4) is not higher than 10¹³ charge carriers/cm².

3. Silicon carbide field-effect transistor according to Claim 1 or 2,
**characterized**
**in that** the trenches for the source and gate electrodes (5, 7) surround the trench for the drain electrode (6).

4. Silicon carbide field-effect transistor according to one of Claims 1 to 3,
**characterized**
**in that** the n- and p-conducting silicon carbide layers (3, 4) are produced by ion implantation and epitaxial deposition on a silicon carbide basic body (1).

## Revendications

1. Transistor à effet de champ au carbure de silicium, comprenant un corps (1, 2) en carbure de silicium, dans lequel sont présentes des couches (3) (4) de conductivité p et n et comprenant des électrodes (5) (6) (7) de source, de drain et de grille,
**caractérisé en ce que**
- les couches (3, 4) en carbure de silicium de conductivité p et n sont incorporées au corps (1, 2) en carbure de silicium par paire dans la direction latérale parallèlement à l'une de ses surfaces principales,
- les électrodes (5) (6) de source et de drain sont constituées de sillons (trench) traversant à partir de l'une des surfaces principales et remplis de carbure de silicium très dopé d'un type de conductivité et
- l'électrode (7) de grille est constituée d'un sillon (trench) traversant à partir de l'une des surfaces principales, rempli de carbure de silicium très dopé du type de conductivité opposé au type de conductivité et revêtu sur ses parois d'une couche (8) isolante.

2. Transistor à effet de champ au carbure de silicium suivant la revendication 1,
**caractérisé**
**en ce que** la concentration de dopage des couches (3, 4) en carbure de silicium de conductivité p et n n'est pas plus grande que 10¹³ porteurs de charge/cm2

3. Transistor à effet de champ au carbure de silicium suivant la revendication 1 et 2,
**caractérisé**
**en ce que** les sillons (trench) pour les électrodes (5, 7) de source et de grille entourent le trench pour l'électrode (6) de drain.

4. Transistor à effet de champ au carbure de silicium suivant l'une des revendications 1 à 3, **caractérisé en ce que** les couches (3, 4) en carbure de silicium de conductivité n et p sont produites par implantation ionique et par dépôt épitaxial sur un corps (1) de base en carbure de silicium.
